# EUROPEAN PATENT APPLICATION

(11) **EP 4 412 433 A1**
(43) Date of publication of application: **07.08.2024**
(21) Application number: 23217137.1
(22) Date of filing: 15.12.2023
(51) Int. Cl.: H10K 59/80

(54) **DISPLAY DEVICE**

(30) Priority: 31.01.2023 KR 20230012809
(71) Applicant: LG Display Co., Ltd., Seoul 07336 (KR)
(72) Inventor: KIM, TaeHo, 10845 Paju-si (KR); KWACK, HeeYoung, 10845 Paju-si (KR); HONG, SukJae, 10845 Paju-si (KR)
(74) Representative: Finlayson, Scott Henry

(57) **Abstract**

Provided is a display device. The display device comprises a substrate divided into a display area in which a plurality of light-emitting elements is disposed, and a sensor hole area included as at least a part of the display area and including a sensor hole through which a part of the substrate is exposed; a plurality of dams disposed in the sensor hole area and including a first dam positioned to be close to the sensor hole, and a second dam positioned to be distant from the sensor hole; a plurality of disconnection parts disposed in the sensor hole area and including a plurality of first disconnection parts positioned between the first dam and the sensor hole, a plurality of second disconnection parts positioned between the first dam and the second dam, and a plurality of third disconnection parts positioned between the second dam and the display area; and a sealing part disposed on the plurality of dams and the plurality of disconnection parts and including at least one of a first inorganic sealing layer, a second inorganic sealing layer, and an organic sealing layer. The first disconnection part has a top surface that is flat in a horizontal direction. The first inorganic sealing layer is disposed on the first disconnection part. The second inorganic sealing layer is disposed to be flat on the first inorganic sealing layer.

## Description

### CROSS-REFERENCE TO RELATED APPLICATIONS

This application claims the priority of Korean Patent Application No. 10-2023-0012809 filed on 31 January, 2023, in the Korean Intellectual Property Office.

### BACKGROUND

### Field

The present specification relates to a display device, and more particularly, to a display device capable of reducing penetration of moisture and impurities.

### Description of the Related Art

Display devices may be used for various types of devices such as TVs, monitors, tablet computers, navigation systems, game consoles, and mobile phones. Various types of display devices such as liquid crystal display (LCD) devices and organic light-emitting display (OLED) devices are used as the display devices. The display device evolves with the addition of a camera, a speaker, a sensor, and the like.

Meanwhile, a hole-in display structure, in which a hole is formed in the display device to dispose a sensor such as a camera, is applied to the display device. However, there is a need to design a new structure to suppress the occurrence of a crack in a camera hole area, and to suppress the penetration of moisture into the hole-in area.

### SUMMARY

An object to be achieved by the present disclosure is to provide a display device capable of blocking upward moisture penetration and/or downward moisture penetration caused by a camera hole.

In detail, when moisture penetrates through an organic light-emitting stack exposed in case that the camera hole is formed, the moisture performs a reaction or propagates along the organic light-emitting stack. The moisture, which propagates as described above, may cause a deterioration in display performance. An object of the present disclosure is to provide a display device capable of eliminating a deterioration in display performance caused by moisture penetration and propagation.

Objects of the present disclosure are not limited to the above-mentioned objects, and other objects, which are not mentioned above, can be clearly understood by those skilled in the art from the following descriptions.

According to an aspect of the present disclosure, a display device includes: a substrate divided into a display area in which a plurality of light-emitting elements is disposed, and a sensor hole area included as at least a part of the display area and including a sensor hole through which a part of the substrate is exposed; a plurality of dams disposed in the sensor hole area and including a first dam positioned to be close to the sensor hole, and a second dam positioned to be distant from the sensor hole; a plurality of disconnection structures disposed in the sensor hole area and including a first disconnection structure positioned between the first dam and the sensor hole, a second disconnection structure positioned between the first dam and the second dam, and a third disconnection structure positioned between the second dam and the display area; and a sealing part disposed on the plurality of dams and the plurality of disconnection structures and including at least one of a first inorganic sealing layer, a second inorganic sealing layer, and an organic sealing layer, in which the first inorganic sealing layer is disposed on the first disconnection structure, and in which the second inorganic sealing layer is disposed to be flat on the first inorganic sealing layer. The first disconnection structure may have a top surface that is flat in a horizontal direction. The horizontal direction may be defined herein as a direction that is parallel with an upper surface of the substrate. Where a surface or layer is described as "flat" herein, it may have an upper surface which is substantially flat, for example an upper surface which does not follow the contours of the underlying layer but instead provides a level upper surface which is substantially free of undulations. Each disconnection structure may comprise a plurality of disconnection parts.

Other detailed matters of the present disclosure are included in the detailed description and the drawings.

The present disclosure may suppress the penetration of moisture and impurities and improve moisture penetration reliability of the display device.

The present disclosure may provide the display device having productivity improved by reducing the number of masks required for the overall process.

The present disclosure may optimize the process by reducing the number of separate processes. This is described in further detail in paragraph [0042] below.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a view illustrating a front surface of a display panel according to an example of the present disclosure;
FIG. 2 is an enlarged top plan view of area A of a display area in FIG. 1;
FIG. 3 is a cross-sectional view of a sub-pixel taken along line I-I' in FIG. 2;
FIG. 4 is an enlarged top plan view of area B corresponding to a sensor hole area in FIG. 1;
FIG. 5 is a cross-sectional view of a sensor hole area CA applied to the display device according to the present disclosure;
FIG. 6 is an enlarged cross-sectional view of area X in FIG. 5; and
FIG. 7 is a cross-sectional view of a sensor hole area CA applied to a display device according to another present disclosure.

### DETAILED DESCRIPTION

Advantages and characteristics of the present disclosure and a method of achieving the advantages and characteristics will be clear by referring to examples described below in detail together with the accompanying drawings. However, the present disclosure is not limited to the examples disclosed herein but will be implemented in various forms. The examples are provided by way of illustration only so that those skilled in the art can fully understand the disclosures of the present disclosure and the scope of the present disclosure.

The shapes, sizes, ratios, angles, numbers, and the like illustrated in the accompanying drawings for describing the examples of the present disclosure are merely illustrations, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including", "having", and "comprising" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

In the description of a temporal relationship, for example, when a temporal relationship between two time points is described by using terms "after," "following," "next to," "before," and the like, the two time points may not be continuous when terms "immediately," or "directly" is not used.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

In describing components of the present disclosure, terms such as first, second, A, B, (a), (b), etc. can be used. These terms are used only to differentiate the components from other components. Therefore, the nature, order, sequence, or number of the corresponding components is not limited by these terms. It is to be understood that when one component is referred to as being "connected to" or "coupled to" another component, it may be directly connected to or directly coupled to another component, connected to or coupled to another component, having still another component "intervening" therebetween, or "connected to" or "coupled to" another component via still another component.

In the present specification, the term "display device" may mean a display device in a narrow sense, such as a liquid crystal module (LCM), an organic light-emitting module (OLED Module), or a quantum dot module, that includes a display panel and a drive unit for operating the display panel. Further, the term "display device" may also mean a set electronic apparatus or a set device (or set apparatus) such as a notebook computer, a television, a computer monitor, an automotive display apparatus, an equipment display apparatus including components for a vehicle, a mobile electronic apparatus such as a smartphone or electronic pad that are finished products (complete products or final products) including the LCM, the OLED module, the QD module, and the like.

Therefore, the display device according to the present specification may mean the display device itself, in a narrow sense, such as the LCM, the OLED module, or the QD module, the application product including the LCM, the OLED module, the QD module, and the like, or a set apparatus that is a final consumer device.

Further, in some instances, the LCM, the OLED module, or the QD module, which includes the display panel and the drive unit, may be expressed as the "display device" in a narrow sense. Further, the electronic apparatus, which is the finished product including the LCM, the OLED module, or the QD module, may be expressed as the "set apparatus" that is distinguished from the display device. For example, the display device in a narrow sense includes the display panel, which is a liquid crystal (LCD) display device, an organic light-emitting (OLED) display device, or a quantum dot display device, and a source PCB that is a control unit for operating the display panel. The set apparatus may include a set PCB that is a set control unit electrically connected to the source PCB and configured to control the entire set apparatus.

The display panel used in the present example may be any form of display panel such as a liquid crystal display panel, an organic light emitting diode (OLED) display panel, a quantum dot (QD) display panel, and an electroluminescent display panel. The display panel of the present example is not limited to a particular display panel including a flexible substrate for an organic electroluminescent (OLED) display panel, and a lower backplate support structure and being capable of being subjected to bezel bending. Further, the shapes or sizes of the display panels used for the display device according to the example of the present specification are not limited.

For example, in case that the display panel is an organic electroluminescent (OLED) display panel, the display panel may include a plurality of gate lines (or a gate line), a plurality of data lines (or a data line), and pixels formed in regions in which the gate lines and the data lines intersect. Further, the display panel may include: an array including thin-film transistors that are elements for selectively applying voltages to the respective pixels; and a sealing substrate or sealing layer (encapsulation) disposed on the array to cover an organic light-emitting element (OLED) layer disposed on the array. The sealing layer may protect the thin-film transistor and the organic light-emitting element layer from external impact and inhibit moisture or oxygen from penetrating into the organic light-emitting element layer. Further, the layer formed on the array may include an inorganic light-emitting layer, for example, a nano-sized material layer or a quantum dot layer.

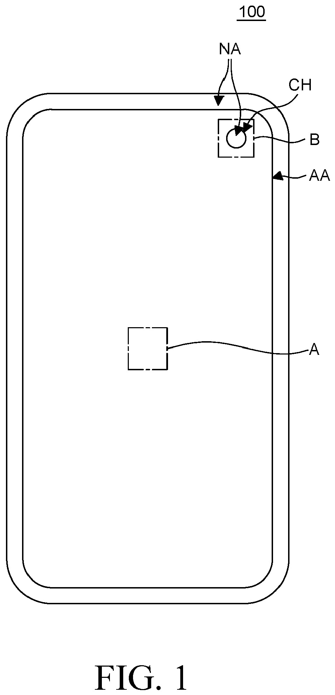

In the present specification, FIG. 1 illustrates a display panel 100, such as an organic electroluminescent display (OLED) panel, that may be integrated into display devices.

FIG. 1 is a top plan view of the display panel 100 according to the present disclosure.

FIG. 1 illustrates the display panel 100 that may be integrated into the display devices. With reference to FIG. 1, in the display panel 100, a sensor hole CH may be disposed in a display area AA, thereby maximizing the display area AA and reducing a bezel area that is a non-display area NA. A design product with the maximized display area AA maximizes a degree of screen immersion of the user, thereby improving an aesthetic appearance.

As illustrated in FIG. 1, the sensor hole CH may be provided as a single hole. However, the present disclosure is not limited thereto. The sensor hole CH may be variously disposed. For example, one or two holes are disposed in the display area AA. A camera may be disposed in a first hole, and a distance detection sensor, a face recognition sensor, or a wide angle camera may be disposed in a second hole.

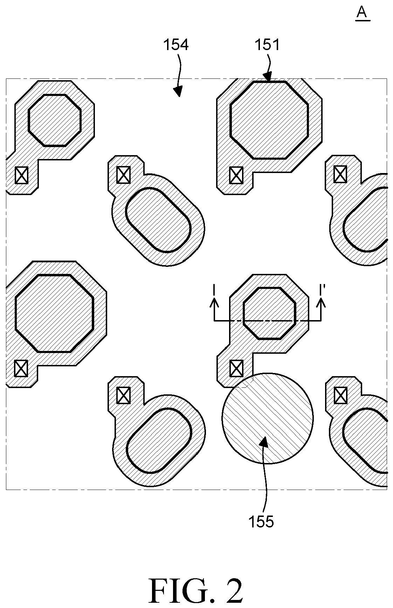

FIG. 2 is an enlarged view of area A, which is a part of the display area AA of the display panel 100 in FIG. 1, and illustrates planar shapes of sub-pixels disposed in the display area AA.

In FIG. 2, a plurality of anodes 151 may be disposed in the display area AA. An area between the anodes 151 may be filled with a bank 154. The bank 154 may be extend over an edge portion of the anode 151, such that the edge portion of the anode 151 is covered by the bank 154. Only a middle area of the anode 151 may be exposed by the bank. The area exposed by the bank may adjoin an organic light-emitting stack and serve to define a light-emitting area of the sub-pixel. A spacer 155 may be disposed in a part of the area in which the bank 154 is disposed. The spacer may be positioned over the bank 154, and may not overlap with the anodes 151. The spacer 155 may be disposed to have a predetermined density in the entire display panel 100. The spacer 155 may serve to support a deposition mask. The deposition mask is configured to selectively cover the display area, leaving open regions for forming the sub-pixels by performing a deposition process to form the organic light-emitting stack. The spacer 155 may serve to support the deposition mask so that the deposition mask does not come into direct contact with the display panel 100. FIG. 2 illustrates a pentile type flat structure in which the subpixels are disposed in a dot shape. However, the present disclosure is not limited thereto. A real type flat structure may be applied.

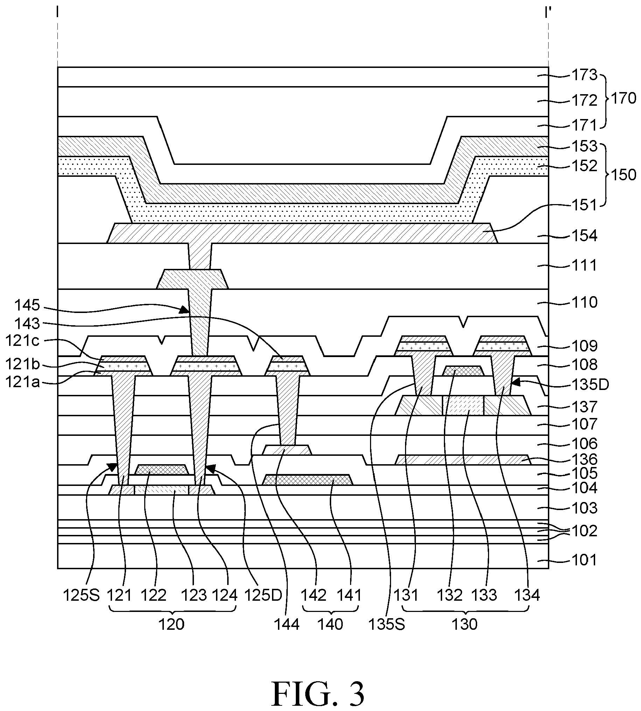

FIG. 3 is a view illustrating a cross-sectional structure of the sub-pixel taken along line I-I' in FIG. 2.

With reference to FIG. 3, a substrate 101, multi-buffer layers 102, and a lower buffer layer 103 may be provided. A first transistor 120 may be disposed on the lower buffer layer 103. A first semiconductor layer 123 is provided to constitute the first transistor 120. A lower gate insulation layer 104 for insulating a first gate electrode 122 may be disposed on the first semiconductor layer 123. A first lower interlayer insulation layer 105 and a second lower interlayer insulation layer 106 may be sequentially disposed on the first gate electrode 122, and an upper buffer layer 107 may be disposed.

The multi-buffer layer 102 may delay diffusion of moisture or oxygen having penetrated into the substrate 101 and be made by alternately stacking silicon nitride (SiNx) and silicon oxide (SiOx) at least once.

The lower buffer layer 103 may serve to protect the first semiconductor layer 123 and suppress various types of defects introduced from the substrate. The lower buffer layer 103 may be made of amorphous silicon (a-Si), silicon nitride (SiNx), silicon oxide (SiOx), or the like.

The first semiconductor layer 123 of the first transistor 120 may be configured as a polycrystalline semiconductor layer. The first semiconductor layer 123 may have a channel area, a source area, and a drain area.

The polycrystalline semiconductor layer has higher mobility, lower energy power consumption, and better reliability than an amorphous semiconductor layer and an oxide semiconductor layer. The polycrystalline semiconductor layer having the above-mentioned advantages may be used for a driving transistor.

The first gate electrode 122 may be disposed on the lower gate insulation layer 104 and disposed to overlap the first semiconductor layer 123.

A second transistor 130 may be disposed on the upper buffer layer 107. A light-blocking layer 136 may be disposed below an area corresponding to the second transistor 130. With reference to FIG. 3, the light-blocking layer 136 may be disposed on the first lower interlayer insulation layer 105 in the area corresponding to the second transistor 130. Asecond semiconductor layer 133 of the second transistor 130 may be disposed on the second lower interlayer insulation layer 106 and the upper buffer layer 107 so as to overlap the light-blocking layer 136. An upper gate insulation layer 137 for insulating a second gate electrode 132 and the second semiconductor layer 133 may be disposed above the second semiconductor layer 133. Further, an upper interlayer insulation layer 108 may be disposed on the second gate electrode 132. The first gate electrode 122 and the second gate electrode 132 may each be configured as a single layer or multilayer made of any one of molybdenum (Mo), aluminum (Al), chromium (Cr), gold (Au), titanium (Ti), nickel (Ni), neodymium (Nd), and copper (Cu) or an alloy thereof. However, the present disclosure is not limited thereto.

The first and second lower interlayer insulation layers 105 and 106 may be formed as an inorganic film having a higher hydrogen particle content than the upper interlayer insulation layer 108. For example, the first and second lower interlayer insulation layers 105 and 106 may each be made of silicon nitride (SiNx) produced by a deposition process using NH₃ gas. The upper interlayer insulation layer 108 may be made of silicon oxide (SiOx). Hydrogen particles contained in the first and second lower interlayer insulation layers 105 and 106 may be diffused to the polycrystalline semiconductor layer during a hydrogenation process, such that pores in the polycrystalline semiconductor layer may be filled with hydrogen. Therefore, the polycrystalline semiconductor layer may be stabilized, which may suppress a deterioration in characteristics of the first transistor 120. The second semiconductor layer 133 of the second transistor 130 may be formed after the process of activating and hydrogenating the first semiconductor layer 123 of the first transistor 120. In this case, the second semiconductor layer 133 may be made of an oxide semiconductor. The second semiconductor layer 133 is not exposed to a high-temperature ambience of the process of activating and hydrogenating the first semiconductor layer 123, which may suppress damage to the second semiconductor layer 133, thereby improving reliability. After the upper interlayer insulation layer 108 is disposed, a first source contact hole 125S and a first drain contact hole 125D may be formed to correspond to a source area and a drain area of a first transistor, and a second source contact hole 135S and a second drain contact hole 135D may be formed to correspond to a source area and a drain area of the second transistor 130.

With reference to FIG. 3, the first source contact hole 125S and the first drain contact hole 125D may be continuously formed from the upper interlayer insulation layer 108 to the lower gate insulation layer 104. The second source contact hole 135S and the second drain contact hole 135D may be formed in the second transistor 130. A first source electrode 121 and a first drain electrode 124, which correspond to the first transistor 120, and a second source electrode 131 and a second drain electrode 134, which correspond to the second transistor 130, may be simultaneously formed. Therefore, it is possible to reduce the number of processes of forming the source electrodes and the drain electrodes of the first transistor 120 and the second transistor 130.

The first source electrode 121, the first drain electrode 124, the second source electrode 131, and the second drain electrode 134 may each be configured as a single layer or multilayer made of any one of molybdenum (Mo), aluminum (Al), chromium (Cr), gold (Au), titanium (Ti), nickel (Ni), neodymium (Nd), and copper (Cu) or an alloy thereof. However, the present disclosure is not limited thereto. The first source electrode 121, the first drain electrode 124, the second source electrode 131, and the second drain electrode 134 may each have a three-layered structure. For example, the first source electrode 121 may include a first layer 121a, a second layer 121b, and a third layer 121c. The other source electrodes and the other drain electrodes may also have the same structure.

A storage capacitor 140 may be disposed between the first transistor 120 and the second transistor 130. As illustrated in FIG. 3, the storage capacitor 140 may be formed as a storage lower electrode 141 and a storage upper electrode 142 overlap each other with the first lower interlayer insulation layer 105 interposed therebetween.

The storage lower electrode 141 may be positioned on the lower gate insulation layer 104. The storage lower electrode 141 may be formed in the same layer and made of the same material as the first gate electrode 122. The storage upper electrode 142 may be electrically connected to a pixel circuit through a storage supply line 143. The storage upper electrode 142 may be formed in the same layer and made of the same material as the light-blocking layer 136. The storage upper electrode 142 is connected to the storage supply line 143 while being exposed through a storage contact hole 144 formed through the second lower interlayer insulation layer 106, the upper buffer layer 107, the upper gate insulation layer 137, and the upper interlayer insulation layer 108.

Meanwhile, as illustrated in FIG. 3, the storage upper electrode 142 is spaced apart from the light-blocking layer 136, so as to not overlap the light-blocking layer 136 in plan view. However, the storage upper electrode 142 may be connected to and integrated with the light-blocking layer 136. The storage supply line 143 may be formed at the same side and made of the same material as the first source electrode 121, the first drain electrode 124, the second source electrode 131, and the second drain electrode 134. Therefore, the storage supply line 143 may be simultaneously formed by the same mask process as the first source electrode 121, the first drain electrode 124, the second source electrode 131, and the second drain electrode 134.

A protective layer 109 may be formed by depositing as an inorganic insulating material such as SiNx or SiOx on the entire surface of the substrate 101 on which the first source electrode 121, the first drain electrode 124, the second source electrode 131, the second drain electrode 134, and the storage supply line 143 are formed. A first planarization layer 110 may be formed on the substrate 101 on which the protective layer 109 is formed. Specifically, an organic insulating material such as acrylic resin is applied onto the entire surface of the substrate 101 on which the protective layer 109 is formed, such that the first planarization layer 110.

The protective layer 109 and the first planarization layer 110 are disposed, and a contact hole, through which the first source electrode 121 or the first drain electrode 124 of the first transistor 120 is exposed, may be formed by a photolithography process. A connection electrode 145, which is made of Mo, Ti, Cu, AINd, Al, Cr, or an alloy thereof, may be disposed in a contact hole area through which the first drain electrode 124 is exposed.

A second planarization layer 111 may be disposed on the connection electrode 145. A contact hole, through which the connection electrode 145 is exposed, may be formed in the second planarization layer 111, such that a light-emitting element 150 connected to the first transistor 120 may be disposed.

The light-emitting element 150 may include the anode 151 connected to the first drain electrode 124 of the first transistor 120, at least one light-emitting layer 152 formed on the anode 151, and a cathode electrode 153 formed on the light-emitting layer 152.

The light-emitting layer 152 may include a hole injection layer, a hole transport layer, a light-emitting layer, an electron transport layer, and an electron injection layer. In a tandem structure in which a plurality of light-emitting layers overlap, a charge generating layer may be additionally disposed between the light-emitting layers. The light-emitting layers may emit light beams with different colors for the respective subpixels. For example, a red light-emitting layer, a green light-emitting layer, and a blue light-emitting layer may be separately formed for each of the subpixels. However, a common light-emitting layer may be formed to emit white light without distinguishing colors for each of the pixels, and color filters for distinguishing colors may be separately provided. The light-emitting layer 152 may be provided as an approximately common layer and equally disposed for each of the subpixels, except that individual light-emitting layers are formed.

A contact hole may be formed through the second planarization layer 111. The anode 151 may be connected to the connection electrode 145 through the contact hole. The anode 151 may have a multilayer structure including a transparent conductive film and an opaque conductive film having high reflection efficiency. The transparent conductive film may be made of a material such as indium-tin-oxide (ITO) or indium-zinc-oxide (IZO) having a comparatively large work function value. The opaque conductive film may have a single-layer or multilayer structure including Al, Ag, Cu, Pb, Mo, Ti, or an alloy thereof. For example, the anode 151 may have a structure made by sequentially stacking the transparent conductive film, the opaque conductive film, and the transparent conductive film. Alternatively, the anode 151 may have a structure made by sequentially stacking the transparent conductive film and the opaque conductive film. The anode 151 may be disposed on the second planarization layer 111 so as to not only overlap the light-emitting area defined by the bank 154 but also overlap a pixel circuit area in which the first and second transistors 120 and 130 and the storage capacitor 140 are disposed, thereby increasing the light-emitting area.

The light-emitting layer 152 may be formed by stacking a hole transport layer, an organic light-emitting layer, and an electron transport layer in this order or in the reverse order on the anode 151. In addition, the light-emitting layer 152 further has a charge generating layer, and first and second light-emitting stacks facing each other with the charge generating layer interposed therebetween.

The bank 154 may be formed to expose the anode 151. The bank 154 may be made of an organic material such as photo acrylic or made of a semi-transparent material. However, the present disclosure is not limited thereto, and the bank 154 may be made of an opaque material to suppress optical interference between the subpixels.

The cathode electrode 153 may be formed on a top surface of the light-emitting layer 152 so as to face the anode 151 with the light-emitting layer 152 interposed therebetween. In a case in which the cathode electrode 153 is applied to a top-emission organic light-emitting display device, the cathode electrode 153 may be configured as a thin transparent conductive film made of indium-tin-oxide (ITO), indium-zinc-oxide (IZO) or magnesium-silver (Mg-Ag).

A sealing part 170 may be formed on the cathode electrode 153 to protect the light-emitting element 150. Because of the nature of the organic material of the light-emitting layer 152, dark-spot or pixel shrinkage may occur as the light-emitting element 150 reacts with outside moisture or oxygen. The sealing part 170 may be disposed on the cathode electrode 153 to suppress the dark-spot or pixel shrinkage. The sealing part 170 may include a first inorganic sealing layer 171, an organic sealing layer 172, and a second inorganic sealing layer 173.

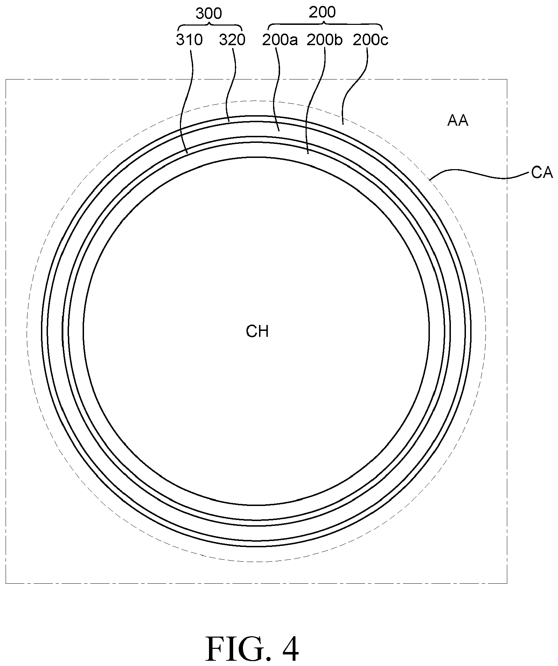

FIG. 4 is an enlarged top plan view of area B corresponding to a sensor hole area in FIG. 1.

With reference to FIG. 4, a large circular space may be present at a center, and a camera or sensor may be disposed in or under the circular space. The sensor hole CH may be formed by removing a corresponding portion of the panel by a laser in a panel completion step. An area corresponding to the sensor hole CH or a partial area including the sensor hole CH may be referred to as a sensor hole area CA. The sensor hole CH may be contained within the sensor hole area CA.

The display area AA surrounds the sensor hole CH. The sensor hole CH is located within a sensor hole area CA. The sensor hole area CA is a non-display area NA. The plurality of dams and a plurality of disconnection structures are located in the sensor hole area CA and surround the sensor hole CH. However, the present disclosure is not limited thereto.

With reference to FIG. 4, a plurality of dam structures 300 and a plurality of disconnection structures 200 may be disposed around the sensor hole CH. The dam structure 300 may include a first dam 310 and a second dam 320, and the plurality of disconnection structures 200 may include a first disconnection structure 200a and a second disconnection structure 200b. The dam(s) and disconnection structure(s) may be located within the sensor hole area CA.

In the sensor hole area CA, the first disconnection structure 200a, the first dam 310, the second disconnection structure 200b, the second dam 320, and a third disconnection structure 200c may be sequentially disposed around the sensor hole CH. The present specification provides two dams. However, the present disclosure is not limited thereto. An additional dam may be disposed in accordance with an arrangement of a space.

The first disconnection structure 200a and the second disconnection structure 200b may be disposed inside the first dam 310 and the second dam 320. For example, the first disconnection structure 200a may be disposed inside the first dam 310, and the second disconnection structure 200b may be disposed inside the second dam 320.

The third disconnection structure 200c may be disposed outside the second dam 320. For example, the second disconnection structure 200b may be disposed inside the second dam 320, and the third disconnection structure 200c may be disposed outside the second dam 320. The third disconnection structure 200c may be excluded. However, the present disclosure is not limited thereto. For example, the third disconnection structure 200c may be disposed between the display area AA and the second dam 320. For example, the third disconnection structure 200c may be disposed between the non-display area NA and the second dam 320.

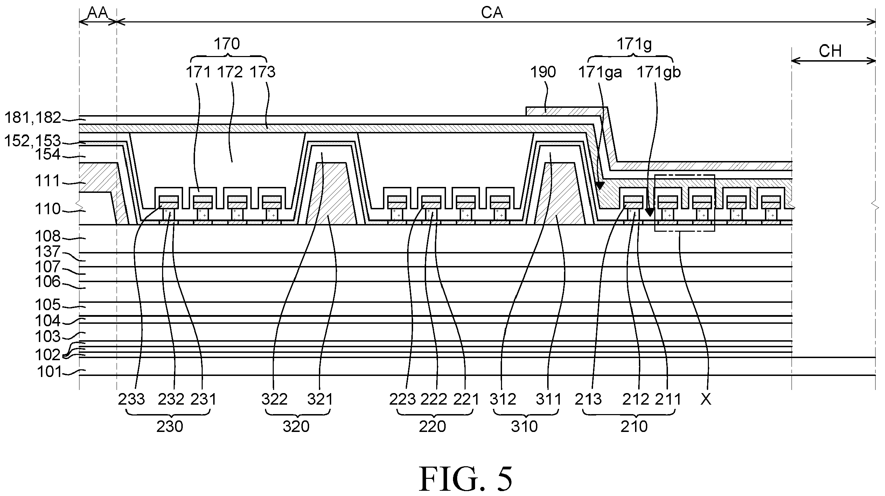

The first disconnection structure 200a, the second disconnection structure 200b, and/or the third disconnection structure 200c may be disposed to protect the light-emitting element (the light-emitting element 150 in FIG. 3) in the display area from moisture and oxygen that may be introduced into the sensor hole area CA. The light-emitting layer 152 for the light-emitting element 150 may be deposited on a front surface of the display panel 100 and may also be uniformly deposited in the sensor hole area CA. Because of the nature of the organic material, the light-emitting layer 152 has high reactivity and dispersity in respect to moisture and oxygen, such that moisture and oxygen may be transmitted to the light-emitting element 150 in the display area AA. The first to third disconnection structures 200a, 200b, 200c may partially disconnect the light-emitting layer 152 to suppress the problem. A detailed description thereof will be described with reference to FIGS. 5 to 7. The present specification provides three disconnection structures. However, the present disclosure is not limited thereto.

In addition to the dam structure 300 and the disconnection structure 200, various lines may be disposed in the non-display area (the non-display area NA in FIG. 1) disposed adjacent to the sensor hole area CA. High-potential power lines, gate lines, and the like may be disposed in the non-display area NA, which is disposed adjacent to the sensor hole area CA, while being connected upward, downward, leftward, and rightward while bypassing the sensor hole area CA.

FIG. 5 is a cross-sectional view of the sensor hole area CA applied to the display device according to the example.

With reference to FIG. 5, the display device may include one or more dams and one or more disconnection structures. Each disconnection structure comprises a plurality of disconnection parts 210, 220, 230. Namely, the first disconnection structure 200a comprises a plurality of first disconnection parts 210, the second disconnection structure 200b comprises a plurality of second disconnection parts 220, and the third disconnection structure 200c comprises a plurality of third disconnection parts 230. The one or more dams may include the first dam 310 and the second dam 320. In the present specification, the first dam 310 means a dam positioned adjacent to the sensor hole CH, and the second dam 320 means a dam positioned adjacent to the display area AA. The second dam 320 is positioned to be distant from the sensor hole CH in comparison with the first dam 310.

The first disconnection structure 200a may be disposed inside the first dam 310. The first disconnection structure 200a may be disposed between the first dam 310 and the sensor hole CH. The first disconnection structure 200a may comprise a plurality of first disconnection parts 210. Five first disconnection parts 210 may be provided. However, the present disclosure is not limited thereto. The plurality of first disconnection parts 210 may be repeatedly disposed at predetermined intervals.

The second disconnection structure 200b may be disposed between the first dam 310 and the second dam 320. The second disconnection structure 200b may comprise a plurality of second disconnection parts 220. Four second disconnection parts 220 may be provided. However, the present disclosure is not limited thereto. The plurality of second disconnection parts 220 may be repeatedly disposed at predetermined intervals.

The third disconnection structure 200c may be disposed outside the second dam 320. The third disconnection structure 200c may be disposed between the second dam 320 and the display area AA. The third disconnection structure 200c may comprise a plurality of third disconnection parts 230. Four third disconnection parts 230 may be provided. However, the present disclosure is not limited thereto. The plurality of third disconnection parts 230 may be repeatedly disposed at predetermined intervals.

The sealing part 170 may be disposed on the first to third pluralities of disconnection parts 210, 220, and 230. The sealing part 170 includes at least one of the first inorganic sealing layer 171, the organic sealing layer 172, and the second inorganic sealing layer 173. For example, the first inorganic sealing layer 171 and the organic sealing layer 172 may be sequentially disposed on the plurality of first disconnection parts 210. For example, the first inorganic sealing layer 171, the organic sealing layer 172, and the second inorganic sealing layer 173 may be sequentially disposed on the plurality of second disconnection parts 220. For example, the first inorganic sealing layer 171, the organic sealing layer 172, and the second inorganic sealing layer 173 may be sequentially disposed on the plurality of third disconnection parts 230.

In other words, the first inorganic sealing layer 171 and the second inorganic sealing layer 173 may be deposited to extend from the sensor hole (CH) to the first dam 310 among the plurality of dams. The organic sealing layer 172 may be absent from the region between the sensor hole CH and the first dam. The first inorganic sealing layer 171, the organic sealing layer 172, and the second inorganic sealing layer 173 may be disposed between the first dam 310 and the second dam 320 among the plurality of dams. The first inorganic sealing layer 171, the organic sealing layer 172, and the second inorganic sealing layer 173 may be disposed between the display area AA and the second dam 320 among the plurality of dams. The organic sealing layer 172 is excluded only from a portion between the first dam 310 and the contact hole, such that the first inorganic sealing layer 171 and the second inorganic sealing layer 173 may be in direct contact with each other only between the first dam 310 and the contact hole. However, the present disclosure is not limited thereto.

The organic sealing layer 172 of the present specification may serve as a planarization layer, and a top surface of the organic sealing layer 172 may be formed to be flat. The second inorganic sealing layer 173 extending from the display area AA to the first dam 310 may be disposed to be flat. The first inorganic sealing layer 171 and the organic sealing layer 172, which are disposed immediately below the second inorganic sealing layer 173, may be continuously disposed in a horizontal direction. For example, the first inorganic sealing layer 171 and the organic sealing layer 172, which are disposed immediately below the second inorganic sealing layer 173, may be disposed so that no groove or almost no groove is formed therebetween. To this end, a thickness of the organic sealing layer 172 disposed on the plurality of second disconnection parts 220 and the plurality of third disconnection parts 230 may be appropriately adjusted.

Unlike the plurality of second disconnection parts 220 or the plurality of third disconnection parts 230, the sealing part 170 disposed on the plurality of first disconnection parts 210 does not include the organic sealing layer 172. In the case of the sealing part 170 disposed on the plurality of first disconnection parts 210, the second inorganic sealing layer 173 is disposed immediately above the first inorganic sealing layer 171. Therefore, in comparison with the plurality of second disconnection parts 220 or the plurality of third disconnection parts 230, a thickness of the sealing part 170 disposed on the plurality of first disconnection parts 210 may be designed to be smaller than a thickness of the sealing part 170 disposed on the plurality of second disconnection parts 220 or the plurality of third disconnection parts 230. A thickness difference may correspond to a thickness of the organic sealing layer 172. Because the organic sealing layer 172 is not disposed on the plurality of first disconnection parts 210, a level difference may be defined between the plurality of first disconnection parts 210 and the first dam 310.

Each disconnection structure of the present specification may include at least a first groove 171ga and a second groove 171gb.

FIG. 5 illustrates that the first groove 171ga refers to a groove formed adjacent to the first dam 310 in the first disconnection structure 200a. However, various examples of the present specification are not limited thereto. The first groove 171ga may also be formed adjacent the first dam 310 in the second disconnection structure 200b, adjacent the second dam 320 in the second disconnection structure 200b, adjacent the second dam 320 in the third disconnection structure 200c, and/or adjacent the display area AA in the third disconnection structure 200c. In the case of the second groove 171gb, FIG. 5 illustrates that the second groove 171gb refers to a groove between the first groove 171ga and the contact hole CH. However, various examples of the present specification are not limited thereto. The second groove 171gb may also be formed on at least one of a position between the first and second dams 310, 320; and/or a position between the second dam 320 and the display area AA.

In the case of the plurality of second disconnection parts 220 and the plurality of third disconnection parts 230, the organic sealing layer 172, which serves as a planarization layer, is disposed on the plurality of second disconnection parts 220 and the plurality of third disconnection parts 230. The first groove 171ga and the second groove 171gb may be filled with the organic sealing layer 172, and the second inorganic sealing layer 173 may be disposed on a surface planarized by the organic sealing layer 172. However, because the organic sealing layer 172 is not disposed on the plurality of first disconnection parts 210, the second inorganic sealing layer 173 may be disposed depending on a shape of a layer disposed immediately below the second inorganic sealing layer 173. For example, in case that a flat surface is formed immediately below the second inorganic sealing layer 173, the second inorganic sealing layer 173 may be disposed to be flat. For example, in case that an inclined surface is formed immediately below the second inorganic sealing layer 173, the second inorganic sealing layer 173 may also be disposed to be inclined. For example, in case that a plurality of grooves and a plurality of recesses are formed immediately below the second inorganic sealing layer 173, the second inorganic sealing layer 173 may also be disposed to have a plurality of grooves and a plurality of recesses.

Foreign substances such as moisture may penetrate in a direction of the first groove 171ga formed between the plurality of first disconnection parts 210 and the first dam 310. The first groove 171ga formed between the plurality of first disconnection parts 210 and the first dam 310 is filled with only the second inorganic sealing layer 173, which makes the display device vulnerable to the moisture penetration. According to various examples of the present specification, a metal layer 190 (which may in some examples be a dummy metal layer 190) may be further disposed on the plurality of first disconnection parts 210 and the first dam 310 to suppress the moisture penetration.

For example, the metal layer 190 may be disposed over an area in which the first dam 310 and at least some of the plurality of first disconnection parts 210 are disposed. The metal layer 190 may be disposed along a top surface of a touch insulation layer disposed on the first dam 310 and the plurality of first disconnection parts 210. The metal layer 190 may be disposed to extend to the first groove 171ga to cover the first groove 171ga. However, the present disclosure is not limited thereto. Because the metal layer 190 is disposed to extend, a side surface of the first dam 310 may be covered by the metal layer 190. The metal layer 190 may block the penetration of foreign substances caused by a level difference defined between the first dam 310 and the plurality of first disconnection parts 210.

In various examples of the present specification, the reason why the first disconnection parts 210 and the second disconnection parts 220 are disposed is to divide the light-emitting layer 152, which is disposed in common in the display area AA and the non-display area NA, from a structure of the disconnection part.

The light-emitting layer 152 may be deposited on the front surface of the display panel 100. A side surface of the light-emitting layer 152 may be exposed in the sensor hole area CA. In case that outside moisture or oxygen penetrates and are diffused through a side surface portion of the light-emitting layer 152, moisture or oxygen may propagate to the light-emitting element 150 in the display area AA. For this reason, there may occur a deterioration in performance and a defect of the light-emitting element 150. To disconnect the transmission path of moisture and oxygen made by the light-emitting layer 152, the structures of the first and second disconnection parts 210 and 220 may be disposed, and the light-emitting layer 152 may be physically disconnected by the shapes of the first to third disconnection parts 210, 220, and 230 and on the principle in which the light-emitting layer 152 is disposed.

At least one of the first to third disconnection parts 210, 220, and 230 may be formed to have a multilayer structure. Therefore, the light-emitting layer 152 may be structurally and assuredly divided to the extent of a height difference defined when at least one of the first to third disconnection parts 210, 220, and 230 is formed to have a multilayer structure. The first disconnection parts 210 may be formed to be high at an outermost periphery closest to the sensor hole area CA to more assuredly suppress the penetration of outside moisture and oxygen. However, the present disclosure is not limited thereto.

Hereinafter, layer structures of the first to third disconnection parts 210, 220, and 230 will be described in more detail. In this case, the description will be focused on the first disconnection parts 210. However, the second disconnection parts 220 and the third disconnection parts 230 may also have substantially the same layer structure. Inotherwords, a first disconnection layer 211, a second disconnection layer 212, and a third disconnection layer 213 of the first disconnection parts 210 may be substantially and respectively identical to a first disconnection layer 221, a second disconnection layer 222, and a third disconnection layer 223 of the second disconnection parts 220. The first disconnection layer 211, the second disconnection layer 212, and the third disconnection layer 213 of the first disconnection parts 210 may be substantially and respectively identical to a first disconnection layer 231, a second disconnection layer 232, and a third disconnection layer 233 of the third disconnection parts 230. Further, the heights of the first to third disconnection parts 210, 220, and 230 and the heights of the layers, which constitute the first to third disconnection parts 210, 220, and 230, may be substantially equal to one another.

As an example, the first disconnection part 210 may have a structure in which the first to third disconnection layers 211, 212, and 213 are sequentially stacked. In this case, the first disconnection layer 211 may correspond to the first layer 121a of the source electrode 121 described with reference to FIG. 3. The second disconnection layer 212 may correspond to the second layer 121b of the source electrode 121. The third disconnection layer 213 may correspond to the third layer 121c of the source electrode 121. The first disconnection layer 211 of the first disconnection part 210 may include the same material as the third disconnection layer 213. The second disconnection layer 212 of the first disconnection part 210 may include a material different from a material of the first disconnection layer 211 and the third disconnection layer 213 of the first disconnection part 210.

The second disconnection layer 212 of the first disconnection part 210 may have a smaller width than the first disconnection layer 211 and the third disconnection layer 213. Therefore, a side surface of the first disconnection part 210 may have a concave shape. The concave portion of the first disconnection part 210 may mean a groove concavely formed inward from an end of the first disconnection layer 211 and an end of the third disconnection layer 213 as a part of the second disconnection layer 212 is removed. Specifically, there is no difference between the ends of the layers when the first disconnection parts 210 are stacked. However, a part of the second disconnection layer 212 may be removed together with the organic insulation layers during a process of forming the first and second dams 310 and 320 in the vicinity of the sensor hole area CA.

In addition, during a process of forming a material for forming the anode 151 on the front surface of the substrate 101 and patterning the anode 151 so that the anode 151 corresponds to the light-emitting element 150, a part of the second disconnection layer 212 may be removed together with the material for forming the anode 151. That is, a part of the second disconnection layer 212 including aluminum (Al) is removed at the time of etching the materials for forming the first and second dams 310 and 320 and the anode 151. The first and third disconnection layers 211 and 213 including titanium (Ti) may not be removed or may be removed less in amount than the second disconnection layer 212. At the end of the first disconnection part 210, a part of a top surface of the first disconnection layer 211 and a part of a bottom surface of the third disconnection layer 213 may be exposed by a concave portion.

Unlike the first to third disconnection parts 210, 220, and 230, the first source electrode 121, the first drain electrode 124, the second source electrode 131, and the second drain electrode 134 are covered by the protective layer 109 and the first planarization layer 110 immediately after the patterning and thus do not have concave side end structures similar to those of the first to third disconnection parts 210, 220, and 230. Therefore, side surfaces of the first layer 121a, the second layer 121b, and the third layer 121c of the first source electrode 121 may be disposed on the same line. In contrast, the first to third disconnection parts 210, 220, and 230 may be exposed in the vicinity of the first and second dams 310 and 320 immediately before the light-emitting layer 152 is formed.

When the light-emitting layer 152 is disposed in the area in which the first to third disconnection parts 210, 220, and 230 are disposed, left and right ends of the structure may be partially disconnected.

According to the principle in which the light-emitting layer 152 is disconnected at the end of the structure, the light-emitting layer 152 may be disposed to form a common layer without a separate deposition mask for dividing the light-emitting layer 152 for each of the subpixels, as disclosed in the description described above with reference to FIG. 3. In the case of the first to third disconnection parts 210, 220, and 230 of the first disconnection part 210 as an example, the light-emitting layer 152 may be structurally divided by a level difference between side ends of the second and third disconnection layers 212 and 213.

The light-emitting layer 152 may be formed by supplying a vaporized organic substance material from a supply source disposed above the substrate 101. The vaporized organic substance material is deposited while having straightness and covers a top surface or a side surface of the third disconnection layer 213 of the first disconnection part 210. However, the vaporized organic substance material is not formed on a side surface of the second disconnection layer 212.

Meanwhile, the first to third disconnection layers 211, 212, 213, 221, 222, 223, 231, 232, and 233 of the disconnection parts (e.g., the first disconnection part, the second disconnection part, and the third disconnection part) according to various exemplary embodiments of the present specification may be formed to be flat in a horizontal direction. Therefore, the light-emitting layer 152 disposed on the first to third disconnection parts 210, 220, and 230 may also be disposed to be flat in the horizontal direction. In particular, the light-emitting layer 152, which is divided by the first to third disconnection parts 210, 220, and 230, may be disposed at vertical positions separated by the first to third disconnection parts 210, 220, and 230 and provided to be flat in the horizontal direction. As described above, the light-emitting layer 152 is vertically divided by the first to third disconnection parts 210, 220, and 230, which may inhibit foreign substances, such as moisture, from penetrating along the light-emitting layer 152.

The first and second dams 310 and 320 may each have an overall width of about 50 µm. Left and right side surfaces of each of the first and second dams 310 and 320 may each have a taper structure having a gradual inclination. However, the present disclosure is not limited thereto. For example, a width of the dam may be about 30 to 60 µm. However, the present disclosure is not limited thereto. In this case, a width of the central area formed to be flat may be about 25 µm. However, the present disclosure is not limited thereto.

The first and second dams 310 and 320 may be formed by stacking the second planarization layer 111, the bank 154, and the spacer 155. However, the present disclosure is not limited thereto. The first and second dams 310 and 320 may be disposed while further including the first planarization layer 110 or other layers.

The first to third disconnection parts 210, 220, and 230 may each be made of a metallic material. For example, the first to third disconnection parts 210, 220, and 230 may be made of the same material and made by the same process as the source electrode and the drain electrode of the transistor. Specifically, the disconnection parts may each have a three-metal-layer structure and have a structure in which titanium (Ti), aluminum (Al), and titanium (Ti) are sequentially stacked. However, the present disclosure is not limited thereto.

Meanwhile, with reference to FIGS. 4 and 5, the first and second dams 310 and 320 may be disposed in the form of a closed circuit around the sensor hole area CA. The first to third disconnection parts 210, 220, and 230 may be disposed in the form of a closed circuit between the first dam 310 and the sensor hole CH, between the first and second dams 310 and 320, and between the second dam 320 and the display area AA.

As illustrated in FIG. 5, with reference to a cross-section in the vicinity of the sensor hole area CA, various insulation layers may be present on the substrate 101 and the display area AA. For example, the multi-buffer layer 102, the lower buffer layer 103, the first lower interlayer insulation layer 105, the second lower interlayer insulation layer 106, the upper buffer layer 107, and the upper interlayer insulation layer 108 may be sequentially stacked on the substrate 101.

The sensor hole area CA may vary depending on a size of a camera or sensor to be applied to a product. The corresponding sensor hole area is illustrated as an empty space, but some insulation layers or wiring structures may be disposed in the sensor hole area. However, a separation description of a dummy area is omitted because the dummy area does not remain in the finished product when the sensor hole area CA is removed by a laser.

The laser beams may be emitted in a circular or elliptical shape depending on the shape of the sensor hole area CA. All the areas on the substrate including the substrate 101 may be removed by the emitted laser beams. There may be a difference between the actual sensor hole area CA and a laser irradiation area. For example, the laser irradiation area of the sensor hole area CA may be an area formed inward by about 100 µm. The difference needs to be defined between the laser irradiation area and the sensor hole area CA so that the insulation layer of the sensor hole area CAis not damaged during the laser irradiation.

A picosecond laser or a femtosecond laser may be used as the laser. However, the present disclosure is not limited thereto. The laser refers to a device that amplifies light generated by applying energy to a particular material and uses light induced and emitted. The laser beams have the same characteristics as radio waves and have directionality of monochromatic light. Therefore, the laser is used for communication, medical, or industrial purposes. A pattern may be easily formed on a desired portion or a particular site may be easily removed by using the laser. The picosecond laser or the femtosecond laser may be classified depending on a laser irradiation time. The picoseconds and femtosecond are units of time. The picosecond is one trillionth of a second (10⁻¹² sec), and the femtosecond is one thousand trillionths of a second (10⁻¹⁵ sec). The picoseconds and femtosecond are too short to be recognized by humans.

The lasers are classified depending on time units because the time it takes to perform irradiation using the picosecond laser is one trillionth of a second, and the time it takes to perform irradiation using the femtosecond laser is one thousand trillionths of a second. The laser utilizes energy to form or remove patterns. When the energy of the laser is emitted onto the object, heat energy melts an object to form patterns.

The longer the pulse is applied, the more thermal effects may occur that are transferred to neighboring areas in which the patterns are formed. This thermal effect is the accumulation of heat around a laser irradiation area of an object, and the heat may burn or deform the surrounding area larger than the set pattern. Because of these characteristics of lasers, in case that the area being irradiated by the laser overlaps or is adjacent to an insulation layer, the thermal energy of the laser may deform the insulation layer. The deformation of the insulation layer may cause cracks, and the cracks may propagate through the insulation layer, which may cause separation of the insulation layer and subsequent penetration of moisture and oxygen. For example, to suppress the deformation or separation of the insulation layers such as the multi-buffer layer 102, the lower buffer layer 103, the first lower interlayer insulation layer 105, the second lower interlayer insulation layer 106, the upper buffer layer 107, and the upper interlayer insulation layer 108, all the insulation layers may be removed with a distance of about 100 µm from a laser irradiation position.

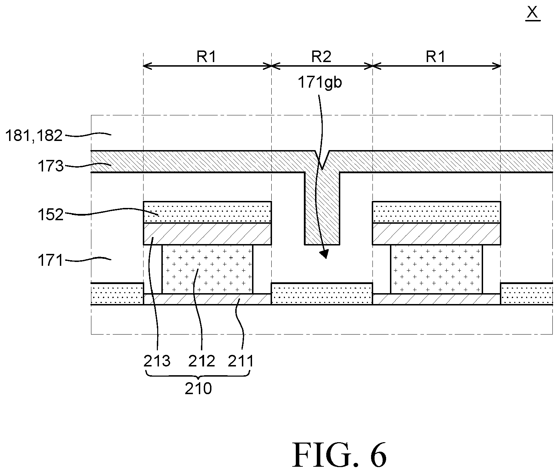

FIG. 6 is an enlarged cross-sectional view of area X in FIG. 5. Specifically, FIG. 6 exemplarily illustrates a cross-sectional structure related to two of the first disconnection parts 210.

With reference to FIG. 6, each first disconnection part 210 includes the first disconnection layer 211, the second disconnection layer 212, and the third disconnection layer 213. The first disconnection layer 211, the second disconnection layer 212, and the third disconnection layer 213 may be sequentially disposed. The metallic materials, which constitute the first disconnection layer 211, the second disconnection layer 212, and the third disconnection layer 213 will be described with reference to FIG. 5. The light-emitting layer 152 may be vertically disconnected by the first disconnection part 210.

The first inorganic sealing layer 171 may be disposed on the first disconnection part 210. The first disconnection part 210 may be disposed to be flat in the horizontal direction. The first inorganic sealing layer 171 disposed on the first disconnection part 210 may be disposed to correspond to the shape of the first disconnection part 210. Therefore, the first inorganic sealing layer may be disposed to be flat on the first disconnection part 210 in part R1 where the first disconnection part 210 is present. The first inorganic sealing layer may be disposed to be flat next to the first disconnection part 210 in part R2 where the first disconnection part 210 is not present.

In various examples of the present specification, each first disconnection part 210 may have a first length, and an interval between the two adjacent first disconnection parts 210 may be a second length.

Unlike the organic sealing layer 172, the first inorganic sealing layer 171 may have an insufficient or no planarization function. Therefore, in case that a thickness of the first inorganic sealing layer 171 disposed on the light-emitting layer 152 is too large, the first inorganic sealing layer 171 may protrude upward in part R2 where the first disconnection parts 210 are not formed. In addition, in case that a thickness of the first inorganic sealing layer 171 disposed on the light-emitting layer 152 is too small, the first inorganic sealing layer 171 has a deep groove in part R2 where the first disconnection parts 210 are not formed, and the groove may facilitate the penetration of foreign substances. The first inorganic sealing layer 171 according to various examples of the present specification may have a length equal to or smaller than approximately 1/2 of the second length between the adjacent first disconnection parts 210.

For example, in case that the first inorganic sealing layer 171 has a thickness of 1/2 of the second length between the first disconnection parts 210, the first inorganic sealing layer 171 does not have a groove in part R2 where the first disconnection parts 210 are not formed, and the second inorganic sealing layer 173 may be disposed to be completely flat on the first inorganic sealing layer 171.

For example, in case that the first inorganic sealing layer 171 has a thickness smaller than 1/2 of the second length between the first disconnection parts 210, the first inorganic sealing layer 171 has a small groove in part R2 where the first disconnection parts 210 are not formed. The small groove is filled with the second inorganic sealing layer 173, and the second inorganic sealing layer 173 may be disposed to be almost flat.

With the above-mentioned design, the second groove 171gb formed between the first disconnection parts 210 is filled with the first inorganic sealing layer 171, and the second inorganic sealing layer 173 disposed immediately above the first inorganic sealing layer 171 is disposed to be substantially flat.

As the second inorganic sealing layer 173 is disposed to be flat, the touch buffer layer and the touch insulation layer disposed immediately above the second inorganic sealing layer 173 may be disposed to be substantially flat.

In various examples of the present specification, the first length may be 2.5 µm to 3.0 µm, and the second length may be 2.0 µm to 2.5 µm. In this case, it can be seen that the degradation of the display device caused by moisture penetration from above the disconnection parts is minimized.

Meanwhile, the second disconnection parts and the third disconnection parts may also be designed to have substantially the same dimension as the first disconnection parts 210.

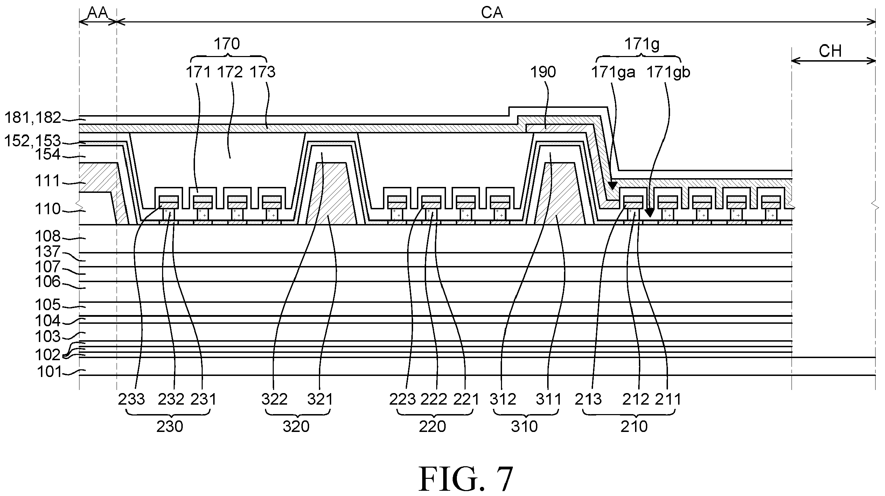

FIG. 7 is a cross-sectional view of a sensor hole area CA applied to a display device according to another example of the present disclosure.

A display device described with reference to FIG. 7 differs from the display device described with reference to FIG. 5 in terms of a position at which the metal layer 190 is disposed. In particular, the metal layer 190 is disposed to extend from the top surface of the first dam 310 to the first groove 171ga, such that a structure in which the second inorganic sealing layer 173, a touch buffer layer 181, and a touch insulation layer 182 are disposed is changed. Hereinafter, the description will be focused on the difference. The description of the contents identical to those described with reference to FIGS. 5 and 6 will be omitted, for convenience.

With reference to FIG. 7, the metal layer 190 may be disposed on the first dam 310. For example, the metal layer 190 may be disposed between the first inorganic sealing layer 171 and the second inorganic sealing layer 173 disposed on the first dam 310. For example, the metal layer 190 may be disposed between the first inorganic sealing layer 171 and the second inorganic sealing layer 173. The metal layer 190 disposed between the first inorganic sealing layer 171 and the second inorganic sealing layer 173 may be disposed to extend from an upper portion of the first dam 310 to the first groove 171ga. Because the metal layer 190 is disposed to extend as described above, the side surface of the first dam 310 may be covered by the metal layer 190.

The metal layer 190 may be disposed to fill the first groove 171ga. Because of a level difference between the first dam 310 and the first disconnection parts, the side surface of the first dam 310 may be exposed to a comparatively wide area, and particularly the moisture penetration may be caused by the first groove 171ga. In case that the metal layer 190 extends from the upper portion of the first dam 310 to the first groove 171ga, the metal layer 190 may basically suppress the moisture penetration from the first groove 171ga. Further, in case that the metal layer 190 is formed to fill the first groove 171ga, the moisture penetration may be further blocked.

The metal layer 190 may further extend from the upper portion of the first dam 310 toward the second dam. However, various examples of the present specification are not limited thereto.

The display device according to the present disclosure includes a liquid crystal display (LCD) device, a field emission display (FED) device, an organic light-emitting display device (OLED), and a quantum dot display device.

The display device according to the present disclosure may also include a set electronic device (apparatus) or a set device (or set apparatus) such as a notebook computer, a television, a computer monitor, an automotive display apparatus, an equipment display apparatus including components for a vehicle, a mobile electronic device (apparatus) such as a smartphone or electronic pad that are finished products (complete products or final products) including the LCM, the OLED module, the OLED module, and the like.

The present disclosure can also be described as follows:

According to an aspect of the present disclosure, there is provided a display device. The display device comprises a substrate divided into a display area in which a plurality of light-emitting elements is disposed, and a sensor hole area included as at least a part of the display area and including a sensor hole through which a part of the substrate is exposed; a plurality of dams disposed in the sensor hole area and including a first dam positioned to be close to the sensor hole, and a second dam positioned to be distant from the sensor hole; a plurality of disconnection parts disposed in the sensor hole area and including a plurality of first disconnection parts positioned between the first dam and the sensor hole, a plurality of second disconnection parts positioned between the first dam and the second dam, and a plurality of third disconnection parts positioned between the second dam and the display area; and a sealing part disposed on the plurality of dams and the plurality of disconnection parts and including at least one of a first inorganic sealing layer, a second inorganic sealing layer, and an organic sealing layer. The first disconnection part has a top surface that is flat in a horizontal direction. The first inorganic sealing layer is disposed on the first disconnection part. The second inorganic sealing layer is disposed to be flat on the first inorganic sealing layer.

Although the examples of the present disclosure have been described in detail with reference to the accompanying drawings, the present disclosure is not limited thereto and may be embodied in many different forms without departing from the technical concept of the present disclosure. Therefore, the examples of the present disclosure are provided for illustrative purposes only but not intended to limit the technical concept of the present disclosure. The scope of the technical concept of the present disclosure is not limited thereto. Therefore, it should be understood that the above-described examples are illustrative in all aspects and do not limit the present disclosure. The protective scope of the present disclosure should be construed based on the following claims. Also disclosed herein are a number of examples according to the following numbered clauses.
1. A display device comprising:
   a substrate divided into a display area in which a plurality of light-emitting elements is disposed, and a sensor hole area included as at least a part of the display area and including a sensor hole through which a part of the substrate is exposed;
   a plurality of dams disposed in the sensor hole area and including a first dam positioned to be close to the sensor hole, and a second dam positioned to be distant from the sensor hole;
   a plurality of disconnection parts disposed in the sensor hole area and including a plurality of first disconnection parts positioned between the first dam and the sensor hole, a plurality of second disconnection parts positioned between the first dam and the second dam, and a plurality of third disconnection parts positioned between the second dam and the display area; and
   a sealing part disposed on the plurality of dams and the plurality of disconnection parts and including at least one of a first inorganic sealing layer, a second inorganic sealing layer, and an organic sealing layer,
   wherein the first disconnection part has a top surface that is flat in a horizontal direction,
   wherein the first inorganic sealing layer is disposed on the first disconnection part, and
   wherein the second inorganic sealing layer is disposed to be flat on the first inorganic sealing layer.
2. The display device of clause 1, wherein the first inorganic sealing layer, the second inorganic sealing layer, and the organic sealing layer between the first inorganic sealing layer and the second inorganic sealing layer are disposed on at least one of the second disconnection part and the third disconnection part.
3. The display device of clause 2, wherein the first inorganic sealing layer disposed on the first disconnection part is in contact with the second inorganic sealing layer,
   wherein the first inorganic sealing layer disposed on the second disconnection part or the third disconnection part is separated from the second inorganic sealing layer with the organic sealing layer interposed therebetween, and
   wherein a top surface of the organic sealing layer is formed to be flat.
4. The display device of any preceding clause, wherein a first groove is formed between the first disconnection part and the first dam, and a second groove is formed between the adjacent first disconnection parts.
5. The display device of clause 4, wherein the first groove defined by the first disconnection part is filled with the first inorganic sealing layer, and the second inorganic sealing layer is disposed to be flat on the first inorganic sealing layer.
6. The display device of clause 4 or clause 5, wherein the second groove defined by the first disconnection part is filled with the first inorganic sealing layer, and the second inorganic sealing layer is disposed to be flat on the first inorganic sealing layer.
7. The display device according to any of clauses 4 to 6, wherein a length of the first disconnection part is 2.5 □m to 3.0 □m in a part where the first disconnection part is present, and
   wherein a distance between the adjacent first disconnection parts is 2.0 □m to 2.5 □m in a part where the first disconnection part is not present.
8. The display device of any preceding clause, further comprising:
   a touch buffer layer and a touch insulation layer sequentially disposed on the sealing part; and
   a dummy metal disposed on the touch insulation layer.
9. The display device of clause 8, wherein the dummy metal is disposed to extend from an upper portion of the first dam to an upper portion of the first disconnection part.
10. The display device of clause 9, wherein the dummy metal is disposed to cover a side surface of the first dam positioned between the first dam and the first disconnection part.
11. The display device of any preceding clause, further comprising:
   a dummy metal disposed between the first inorganic sealing layer and the second inorganic sealing layer.
12. The display device of clause 11, wherein the dummy metal is disposed to extend from an upper portion of the first dam to a first groove formed between the first dam and the first disconnection part.
13. The display device of clause 12, wherein the dummy metal is disposed to fill the first groove.
14. The display device of claim 1, wherein at least one of the first to third disconnection parts is formed to have a structure in which the first to third disconnection layers are sequentially stacked.
15. The display device of claim 14, wherein the second disconnection layer of the first disconnection part has a smaller width than the first disconnection layer and the third disconnection layer.
16. A display device comprising:
   a substrate divided into a display area in which a plurality of light-emitting elements is disposed, and a sensor hole area included as at least a part of the display area and including a sensor hole through which a part of the substrate is exposed;
   a plurality of dams and a plurality of disconnection parts disposed in the sensor hole area;
   a sealing part disposed on the plurality of dams and the plurality of disconnection parts and including at least one of a first inorganic sealing layer, a second inorganic sealing layer, and an organic sealing layer; and
   a dummy metal disposed on the sealing part,
   wherein the plurality of dams includes a first dam positioned to be close to the sensor hole, and a second dam positioned to be distant from the sensor hole,
   wherein the plurality of disconnection parts includes a plurality of first disconnection parts positioned between the first dam and the sensor hole, and a plurality of second disconnection parts positioned between the first dam and the second dam, and
   wherein the dummy metal is disposed to extend from an upper portion of the first dam to at least some of the plurality of first disconnection parts.
17. A display device comprising:
   a substrate divided into a display area in which a plurality of light-emitting elements is disposed, and a sensor hole area included as at least a part of the display area and including a sensor hole through which a part of the substrate is exposed;
   a plurality of dams and a plurality of disconnection parts disposed in the sensor hole area;
   a sealing part disposed on the plurality of dams and the plurality of disconnection parts and including at least one of a first inorganic sealing layer, a second inorganic sealing layer, and an organic sealing layer; and
   a dummy metal disposed between the first inorganic sealing layer and the second inorganic sealing layer,
   wherein the plurality of dams includes a first dam positioned to be close to the sensor hole, and a second dam positioned to be distant from the sensor hole,
   wherein the plurality of disconnection parts includes a plurality of first disconnection parts positioned between the first dam and the sensor hole, and a plurality of second disconnection parts positioned between the first dam and the second dam, and
   wherein the dummy metal is disposed to extend from an upper portion of the first dam to a first groove formed between the first dam and the first disconnection part.

## Claims

1. A display device (100) comprising:
a substrate (101) divided into a display area (AA) in which a plurality of light-emitting elements is disposed, and a sensor hole area (CA) included as at least a part of the display area and including a sensor hole (CH) through which a part of the substrate is exposed;
a plurality of dams (310, 320) disposed in the sensor hole area and including a first dam (310) positioned to be close to the sensor hole, and a second dam (320) positioned to be distant from the sensor hole;
a plurality of disconnection structures (200a, 200b, 200c) disposed in the sensor hole area and including a first disconnection structure (200a) positioned between the first dam and the sensor hole, a second disconnection structure (200b) positioned between the first dam and the second dam, and a third disconnection structure (200c) positioned between the second dam and the display area; and
a sealing part (170) disposed on the plurality of dams and the plurality of disconnection structures and including at least one of a first inorganic sealing layer (171), a second inorganic sealing layer (173), and an organic sealing layer (172),
wherein the first inorganic sealing layer is disposed on the first disconnection structure, and
wherein the second inorganic sealing layer is disposed to be substantially flat on the first inorganic sealing layer.

2. The display device of claim 1, wherein the display area surrounds the sensor hole area, and wherein the sensor hole is located within the sensor hole area.

3. The display device of claim 1 or claim 2, wherein the first inorganic sealing layer and the second inorganic sealing layer extend across each of the dams and across each of the disconnection structures.

4. The display device of any preceding claim, wherein the organic sealing layer is provided in at least one of the disconnection structures and does not extend to the dams.

5. The display device of claim 4 when dependent on claim 3, wherein the organic sealing layer is sandwiched between the first inorganic sealing layer and the second inorganic sealing layer in the at least one of the disconnection structures.

6. The display device of claim 4 or claim 5, wherein the organic sealing layer is not provided in the first disconnection structure, such that the first inorganic sealing layer contacts the second inorganic sealing layer in the first disconnection structure.

7. The display device of any preceding claim, wherein a top surface of the sealing layer is substantially flat over the first and second dams and over the second and third disconnection structures.

8. The display device according to any preceding claim, wherein at least one of the plurality of disconnection structures includes a plurality of grooves (171ga, 171gb) formed therein.

9. The display device according to claim 8, further comprising a metal layer (190) provided on at least a side surface of the first dam, wherein the metal layer extends to a groove of the plurality of grooves, wherein the groove is formed adjacent a corresponding edge of the first disconnection structure.

10. The display device of claim 9, wherein the metal layer is provided under the second inorganic sealing layer.

11. The display device according to any of claims 8 to 10, wherein at least one of the disconnection structures comprises a first disconnection layer (211), a second disconnection layer (212), and a third disconnection layer (213), wherein the first second, and third disconnection layers are stacked on top of one another to form a plurality of stacks, and wherein the stacks define disconnection parts with grooves defined therebetween.

12. The display device according to any preceding claim, wherein each dam has a base width of between 30µm and 60µm.

13. The display device according to any preceding claim, wherein each dam has a tapered structure with sloped side-surfaces.

14. The display device according to any preceding claim 13, wherein a top surface of each dam has a width of between 20µm and 30µm.

15. The display device according to any preceding claim, wherein each dam forms a closed loop which surrounds the contact hole.
